# DEMANDE DE BREVET EUROPEEN

(11) **EP 4 047 649 A1**
(43) Date de publication de la demande: **24.08.2022**
(21) Numéro de dépôt: 22157346.2
(22) Date de dépôt: 17.02.2022
(51) Int. Cl.: H01L 23/60, H01L 23/00, H01L 25/065, H01L 25/00, H01L 21/02, H01L 21/822, H01L 27/02, H01L 23/48, H01L 21/768, H01L 23/522, H01L 21/84

(54) **PROCÉDÉ DE PROTECTION D'UN ÉTAGE SUPÉRIEUR DE COMPOSANTS ÉLECTRONIQUES D'UN CIRCUIT INTÉGRÉ CONTRE L'EFFET D'ANTENNE**

(30) Priorité: 23.02.2021 FR 2101763
(71) Demandeur: Commissariat à l'énergie atomique et aux énergies alternatives, 75015 Paris (FR)
(72) Inventeur: BILLOINT, Olivier, 38054 Grenoble Cedex 09 (FR)
(74) Mandataire: INNOV-GROUP

(57) **Abrégé**

Ce procédé comporte les étapes :
a) prévoir une première structure comportant successivement :
- un premier substrat (1), comportant une première surface (10),
- un premier étage (BT) de composants électroniques (C), formé à la seconde surface (11) du premier substrat (1),
- un premier empilement, présentant un dernier niveau de métallisation (M_{N}) électriquement connecté à la seconde surface (11) du premier substrat (1) ;

b) prévoir une deuxième structure comportant :
- un deuxième substrat (2), comprenant un trou d'interconnexion traversant (22),
- un deuxième étage (TT) de composants électroniques (C) comprenant des composants de protection (3) agencés pour évacuer des charges électriques dans le deuxième substrat (2) ;

c) assembler les première et deuxième structures de sorte que le trou d'interconnexion traversant (22) est électriquement connecté au dernier niveau de métallisation (M_{N}) du premier empilement ;
d) former un deuxième empilement sur le deuxième étage (TT), présentant un premier niveau de métallisation (M₁) électriquement connecté au trou d'interconnexion traversant (22) et à la première surface (20) du deuxième substrat (2).

## Description

### Domaine technique

L'invention se rapporte au domaine technique de la fabrication de plusieurs étages de composants électroniques d'un circuit intégré, avec une intégration 3D à très grande échelle (VLSI pour « *Very-Large-Scale Integration* » en langue anglaise).

L'invention trouve notamment son application dans la technologie CoolCube^{™}.

### État de l'art

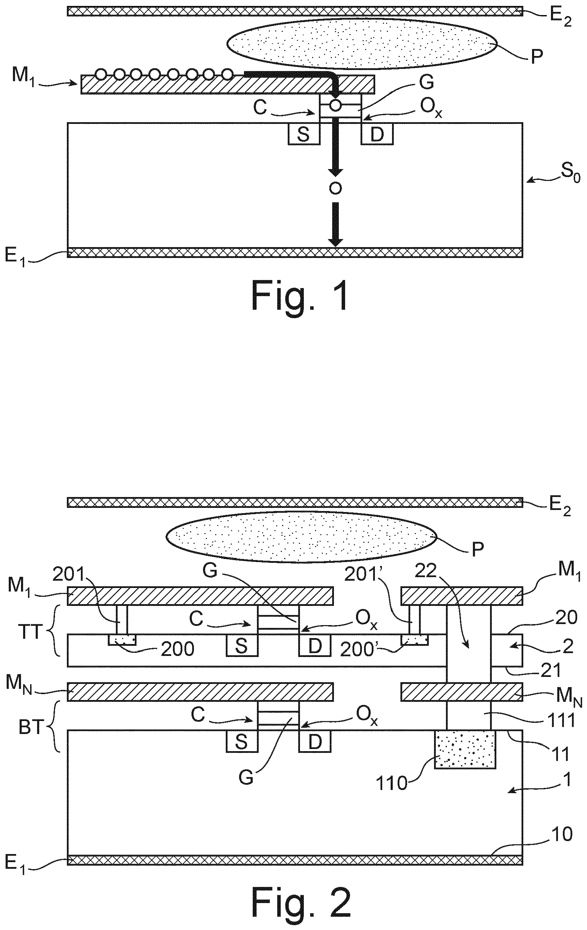

Comme illustré à la figure 1, l'effet d'antenne (« *Antenna effect*» en langue anglaise) est un phénomène de dégradation d'un étage de composants électroniques C (formé à la surface supérieure d'un substrat S₀) lors d'une gravure par un plasma P, après la fabrication d'un premier niveau de métallisation M₁ sur l'étage de composants électroniques C. La gravure par plasma P nécessite une électrode de polarisation E₁, électriquement connectée à la surface inférieure du substrat S₀, et une électrode de masse E₂. L'effet d'antenne concerne les composants électroniques C comportant une couche d'oxyde Ox, par exemple des transistors de type MOS (comme illustré à la figure 1 avec une source S, une grille G, et un drain D) ou des mémoires résistives à base d'oxyde. Plus précisément, la gravure par plasma P va charger électriquement la surface métallique du premier niveau de métallisation M₁ lors de l'application d'une différence de potentiel entre l'électrode de polarisation E₁ et l'électrode de masse E₂. Or, la surface métallique du premier niveau de métallisation M₁ est électriquement connectée à la couche d'oxyde Ox. Des charges électriques vont alors s'accumuler jusqu'à endommager la couche d'oxyde Ox, tout particulièrement lorsque la couche d'oxyde Ox est fine.

Pour pallier ce problème, trois solutions principales sont connues de l'état de la technique :
(i) utilisation d'un transistor factice (« *dummy transistor*» en langue anglaise), formé à la surface supérieure du substrat S₀, et électriquement connecté au premier niveau de métallisation M₁ de manière à évacuer les charges électriques dans le substrat S₀ vers l'électrode de polarisation E₁ ;
(ii) utilisation d'une jonction p-n, formée dans une zone superficielle du substrat S₀, électriquement connectée au premier niveau de métallisation M₁, et polarisée en inverse de manière à évacuer les charges électriques dans le substrat S₀ vers l'électrode de polarisation E₁ ;
(iii) utilisation de ponts métalliques (« *metal-hopping*» en langue anglaise) lors d'une fabrication séquentielle du premier niveau de métallisation M₁ afin de réduire l'aire de sa surface métallique et par là-même réduire l'accumulation de charges électriques sur la surface métallique qui va donc diminuer la tension aux bornes de la couche d'oxyde Ox.

Ces solutions de l'état de la technique ne sont pas entièrement satisfaisantes pour protéger l'étage supérieur de composants électroniques C contre l'effet d'antenne, dans le cas d'une intégration 3D. En effet, les solutions (i) et (ii) ne permettent pas d'évacuer efficacement les charges électriques dans le substrat supérieur vers l'électrode de polarisation E₁. La solution (iii) nécessite, quant à elle, énormément de ressources en lignes d'interconnexion, et n'est donc pas souhaitable pour une intégration VLSI.

### Exposé de l'invention

L'invention vise à remédier en tout ou partie aux inconvénients précités. A cet effet, l'invention a pour objet un procédé de protection d'un étage supérieur de composants électroniques d'un circuit intégré contre l'effet d'antenne, comportant les étapes :
a) prévoir une première structure comportant successivement :
   - un premier substrat, semi-conducteur, présentant des première et seconde surfaces opposées, la première surface du premier substrat étant destinée à être électriquement connectée à une électrode de polarisation,
   - un premier étage de composants électroniques, formé à la seconde surface du premier substrat,
   - un premier empilement de niveaux de métallisation, agencé pour connecter électriquement les composants électroniques du premier étage, et présentant un dernier niveau de métallisation électriquement connecté à la seconde surface du premier substrat ;
b) prévoir une deuxième structure comportant :
   - un deuxième substrat, semi-conducteur, présentant des première et seconde surfaces opposées, le deuxième substrat comprenant un trou d'interconnexion traversant,
   - un deuxième étage de composants électroniques, formé à la première surface du deuxième substrat, et comprenant des composants de protection agencés pour évacuer des charges électriques dans le deuxième substrat ;
c) assembler les première et deuxième structures de sorte que la seconde surface du deuxième substrat est orientée vers le premier empilement de niveaux de métallisation, et de sorte que le trou d'interconnexion traversant est électriquement connecté au dernier niveau de métallisation du premier empilement ;
d) former un deuxième empilement de niveaux de métallisation, agencé pour connecter électriquement les composants électroniques du deuxième étage ; l'étape d) étant exécutée de sorte que le deuxième empilement présente un premier niveau de métallisation électriquement connecté au trou d'interconnexion traversant et à la première surface du deuxième substrat.

Autrement dit, l'étape a) est exécutée de sorte que le premier empilement de niveaux de métallisation présente un dernier niveau de métallisation comprenant un motif électriquement connecté à la seconde surface du premier substrat.

Autrement dit, l'étape b) est exécutée de sorte que le deuxième étage comporte :
- des composants électroniques, à protéger contre l'effet d'antenne ;
- des composants de protection, distincts des composants électroniques à protéger contre l'effet d'antenne, agencés pour évacuer des charges électriques dans le deuxième substrat.

En d'autres termes, les composants électroniques du deuxième étage et les composants de protection du deuxième étage sont des entités distinctes, ne pouvant être confondues. Chaque composant de protection ne fait pas partie intégrante d'un composant électronique à protéger contre l'effet d'antenne.

Autrement dit, l'étape c) est exécutée de sorte que le trou d'interconnexion traversant est électriquement connecté au motif du dernier niveau de métallisation du premier empilement.

Autrement dit, l'étape d) est exécutée de sorte que le deuxième empilement de niveaux de métallisation présente un premier niveau de métallisation comprenant un motif électriquement connecté au trou d'interconnexion traversant et à la première surface du deuxième substrat.

L'étape d) utilise une gravure par un plasma. L'étape d) est exécutée après l'étape c).

### Définitions

- Par « substrat », on entend un support physique autoporté, réalisé dans un matériau de base à partir duquel peut être formé un composant électronique. Un substrat est classiquement une plaquette (« *wafer*» en langue anglaise) découpée dans un lingot monocristallin de matériau semi-conducteur.
- Par « semi-conducteur », on entend que le substrat présente une conductivité à 300 K comprise entre 10⁻⁸ S/cm et 10³ S/cm.
- Par « formés à la surface », on entend que les composants électroniques sont formés sur et/ou à travers la surface.
- Par « niveaux de métallisation », on entend des pistes métalliques, noyées dans un matériau diélectrique, formant une structure d'interconnexion. Chaque niveau de métallisation comporte des lignes d'interconnexion (lignes de routage) électriquement isolées entre elles. Il est ainsi possible de considérer que chaque niveau de métallisation comporte des motifs électriquement isolés entre eux (les uns des autres).
- Par « empilement», on entend une succession de niveaux de métallisation suivant une direction verticale (i.e. suivant la normale aux surfaces des premier et deuxième substrats).
- Par « dernier niveau de métallisation », on entend le niveau de métallisation de l'empilement formé en dernier, classiquement par une unité de fabrication finale BEOL (« *Back-End-Of-Line* » en langue anglaise), ce qui correspond au niveau de métallisation le plus élevé de l'empilement.
- Par « premier niveau de métallisation », on entend le niveau de métallisation de l'empilement formé en premier, classiquement par une unité de fabrication finale BEOL (« *Back-End-Of-Line* » en langue anglaise), ce qui correspond au niveau de métallisation le plus bas de l'empilement.
- Par «trou d'interconnexion» (« *via* » en langue anglaise), on entend un trou métallisé permettant d'établir une liaison électrique. Un trou d'interconnexion traversant s'étend verticalement entre les première et seconde surfaces du deuxième substrat de manière à établir une connexion électrique entre lesdites surfaces. Dans le cas où le deuxième substrat est réalisé en silicium, le trou d'interconnexion traversant est de type TSV (« *Through-Silicon Via* » en langue anglaise).

Ainsi, un tel procédé selon l'invention permet d'évacuer efficacement les charges électriques présentes à la surface métallique du premier niveau de métallisation (et des suivants) du deuxième empilement, lors d'une gravure plasma, en créant un chemin faiblement résistif vers la première surface du premier substrat, et donc vers l'électrode de polarisation. Plus précisément, les charges électriques présentes à la surface métallique du premier niveau de métallisation du deuxième empilement vont être évacuées successivement :
- vers le deuxième substrat via les composants de protection, puis
- vers le trou d'interconnexion traversant via la première surface du deuxième substrat (par l'intermédiaire du premier niveau de métallisation du deuxième empilement, c'est-à-dire par l'intermédiaire du motif du premier niveau de métallisation du deuxième empilement électriquement connecté au trou d'interconnexion traversant et à la première surface du deuxième substrat), puis
- vers le dernier niveau de métallisation du premier empilement (c'est-à-dire vers le motif du dernier niveau de métallisation du premier empilement électriquement connecté au trou d'interconnexion traversant et à la seconde surface du premier substrat), puis
- vers la seconde surface du premier substrat, et enfin
- vers la première surface du premier substrat (et donc vers l'électrode de polarisation).

Le procédé selon l'invention peut comporter une ou plusieurs des caractéristiques suivantes.

Selon une caractéristique de l'invention, l'étape b) est exécutée de sorte que le deuxième substrat est dopé d'un premier type conductivité ; l'étape b) comporte une étape b₃) consistant à former une première zone dopée, d'un second type de conductivité, à la première surface du deuxième substrat de manière à former une jonction p-n ; la jonction p-n étant destinée à être polarisée en inverse de manière à obtenir un composant de protection ; et l'étape d) est exécutée de sorte que le premier niveau de métallisation du deuxième empilement est électriquement connecté à la première zone dopée formée lors de l'étape b₃).

Autrement dit, l'étape d) est exécutée de sorte que le motif du premier niveau de métallisation du deuxième empilement est électriquement connecté à la première zone dopée formée lors de l'étape b₃).

### Définition

- Le terme « dopé » signifie la présence d'impuretés (espèces), qui introduites dans une matrice d'un matériau semi-conducteur, donnent un électron à la bande de conduction (dopants de type n) ou acceptent un électron de la bande de conduction (dopants de type p).
- L'expression « second type de conductivité » désigne un type de conductivité opposé au premier type de conductivité.

Ainsi, un avantage procuré par une telle jonction p-n est de pouvoir évacuer les charges électriques présentes à la surface métallique du premier niveau de métallisation du deuxième empilement dans le deuxième substrat.

Selon une caractéristique de l'invention, l'étape b) comporte une étape b'₃) consistant à former une capacité de type MOS à la première surface du deuxième substrat de manière à obtenir un composant de protection ; et l'étape d) est exécutée de sorte que le premier niveau de métallisation du deuxième empilement est électriquement connecté à la capacité de type MOS formée lors de l'étape b'₃).

Autrement dit, l'étape d) est exécutée de sorte que le motif du premier niveau de métallisation du deuxième empilement est électriquement connecté à la capacité de type MOS formée lors de l'étape b'₃).

### Définition

Par « de type MOS » on entend une structure Métal-Oxyde-Semiconducteur.

Ainsi, un avantage procuré par une telle capacité MOS est de pouvoir évacuer les charges électriques présentes à la surface métallique du premier niveau de métallisation du deuxième empilement dans le deuxième substrat. En outre, une capacité de type MOS possède un courant de fuite plus élevé qu'une jonction p-n polarisée en inverse, à taille égale, ce qui permet d'améliorer l'efficacité de l'évacuation des charges électriques présentes à la surface métallique du premier niveau de métallisation du deuxième empilement.

Selon une caractéristique de l'invention, l'étape a) est exécutée de sorte que :
- le premier substrat est dopé d'un premier type de conductivité,
- une zone fortement dopée, du premier type de conductivité ou d'un second type de conductivité, est formée à la seconde surface du premier substrat,
- le dernier niveau de métallisation du premier empilement est électriquement connecté à la zone fortement dopée.

Autrement dit, l'étape a) est exécutée de sorte que le motif du dernier niveau de métallisation du premier empilement est électriquement connecté à la zone fortement dopée.

### Définition

Par « fortement dopée », on entend que les dopants de la zone fortement dopée ont une concentration au moins 10 fois supérieure à la concentration des dopants du premier substrat.

Ainsi, un avantage procuré est de :
- soit pouvoir former un contact électrique faiblement résistif entre les premier et deuxième substrats lorsque la zone fortement dopée est dopée du premier type de conductivité, et évacuer les charges électriques de la seconde surface du premier substrat vers la première surface du premier substrat ;
- soit pouvoir polariser les premier et deuxième substrats à des potentiels électriques différents lorsque la zone fortement dopée est dopée du second type de conductivité, et ce tout en autorisant l'évacuation des charges électriques de la seconde surface du premier substrat vers la première surface du premier substrat ; la zone fortement dopée du second type de conductivité forme une jonction p-n, destinée à être polarisée en inverse, de manière à isoler électriquement les premier et deuxième substrats ; le courant de fuite de la jonction p-n polarisée en inverse permet d'évacuer les charges électriques de la seconde surface du premier substrat vers la première surface du premier substrat.

Selon une caractéristique de l'invention, les étapes a) et b) sont exécutées de sorte que les composants électroniques des premier et deuxième étages, hormis les composants de protection, sont choisis parmi :
- des transistors à effet de champ de type MOS formés sur un substrat massif,
- des transistors à effet de champ de type MOS formés sur un substrat de type SOI,
- des transistors à effet de champ de type MOS à ailettes formés sur un substrat massif,
- des transistors à effet de champ de type MOS à ailettes formés sur un substrat de type SOI, et
- des mémoires résistives à base d'oxyde.

### Définitions

- Par « substrat massif » (*bulk substrate* en langue anglaise), on entend un substrat possédant un seul matériau constitutif.
- Par « de type SOI » (*Silicon-On-Insulator* en langue anglaise), on entend silicium sur isolant, c'est-à-dire un substrat de type silicium/isolant/silicium.
- Le terme « substrat » désigne le premier substrat (respectivement le deuxième substrat) lorsqu'il s'agit d'un composant électronique du premier étage (respectivement du deuxième étage).

Ainsi, de tels composants électroniques sont particulièrement sujets à l'effet d'antenne en raison de la présence d'une couche d'oxyde fine.

Selon une caractéristique de l'invention, les étapes a) et b) sont exécutées de sorte que les premier et deuxième substrats sont des plaquettes réalisées en silicium.

Selon une caractéristique de l'invention, l'étape a) comporte les étapes :
a₁) prévoir le premier substrat, semi-conducteur, présentant des première et seconde surfaces opposées, la première surface du premier substrat étant destinée à être électriquement connectée à une électrode de polarisation ;
a₂) former le premier étage de composants électroniques à la seconde surface du premier substrat ; l'étape a₂) étant exécutée par une unité de fabrication initiale ;
a₃) former le premier empilement de niveaux de métallisation, agencé pour connecter électriquement les composants électroniques du premier étage, et présentant un dernier niveau de métallisation électriquement connecté à la seconde surface du premier substrat ; l'étape a₃) étant exécutée par une unité de fabrication finale.

Autrement dit, l'étape a₃) est exécutée de sorte que le premier empilement de niveaux de métallisation présente un dernier niveau de métallisation comprenant un motif électriquement connecté à la seconde surface du premier substrat.

### Définition

Le terme « unité de fabrication initiale » est classiquement désigné par l'acronyme FEOL (« *Front-End-Of-Line* » en langue anglaise).

Selon une caractéristique de l'invention, l'étape b) comporte les étapes :
b₁) prévoir le deuxième substrat, semi-conducteur, présentant des première et seconde surfaces opposées, le deuxième substrat comprenant un trou d'interconnexion traversant ;
b₂) former le deuxième étage de composants électroniques à la première surface du deuxième substrat ; l'étape b₂) étant exécutée par une unité de fabrication initiale.

Selon une caractéristique de l'invention, l'étape d) est exécutée par une unité de fabrication finale.

Selon une caractéristique de l'invention, l'étape c) est exécutée par un collage par adhésion moléculaire entre les première et deuxième structures par l'intermédiaire d'au moins une couche d'oxyde.

### Définition

Par « collage par adhésion moléculaire », on entend un collage spontané issu de la mise en contact direct de deux surfaces, c'est-à-dire en l'absence d'un élément additionnel tel qu'une colle, une cire ou une brasure. L'adhésion provient principalement des forces de van der Waals issues de l'interaction électronique entre les atomes ou les molécules de deux surfaces, des liaisons hydrogène du fait des préparations des surfaces ou des liaisons covalentes établies entre les deux surfaces.

Selon une caractéristique de l'invention, l'étape b) est exécutée de sorte que le deuxième substrat est dopé d'un premier type conductivité ; l'étape b) comporte une étape b₄) consistant à former une deuxième zone dopée, fortement dopée du premier type de conductivité, à la première surface du deuxième substrat ; et l'étape d) est exécutée de sorte que le premier niveau de métallisation du deuxième empilement est électriquement connecté à la deuxième zone dopée formée lors de l'étape b₄).

Autrement dit, l'étape d) est exécutée de sorte que le motif du premier niveau de métallisation du deuxième empilement est électriquement connecté à la deuxième zone dopée formée lors de l'étape b₄).

Ainsi, un avantage procuré est de créer une connexion électrique entre le trou d'interconnexion traversant et la première surface du deuxième substrat, par l'intermédiaire du premier niveau de métallisation du deuxième empilement (c'est-à-dire par l'intermédiaire du motif du premier niveau de métallisation du deuxième empilement).

### Brève description des dessins

D'autres caractéristiques et avantages apparaîtront dans l'exposé détaillé de différents modes de réalisation de l'invention, l'exposé étant assorti d'exemples et de références aux dessins joints.
Figure 1 (déjà commentée) est une vue schématique en coupe d'un substrat comportant un étage de composants électroniques, illustrant l'effet d'antenne.
Figure 2 est une vue schématique partielle, en coupe, d'un assemblage des première et deuxième structures où le premier niveau de métallisation du deuxième empilement est construit, et illustrant un premier mode de mise en œuvre d'un procédé selon l'invention. Il est à noter que seul le dernier niveau de métallisation du premier empilement est représenté par souci de simplification. Le matériau diélectrique dans lequel sont noyés les empilements de niveaux de métallisation n'est pas représenté par souci de lisibilité.

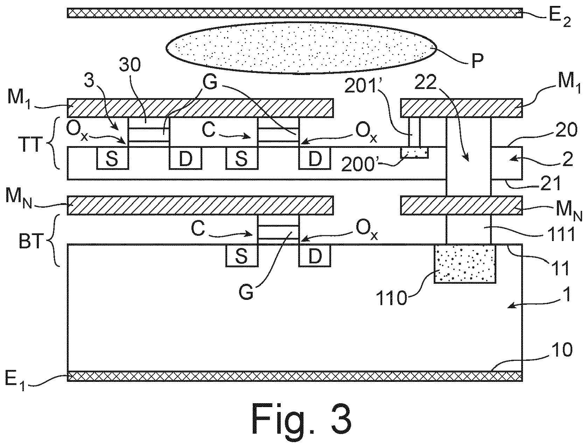

Figure 3 est une vue schématique partielle, en coupe, d'un assemblage des première et deuxième structures où le premier niveau de métallisation du deuxième empilement est construit, et illustrant un deuxième mode de mise en œuvre d'un procédé selon l'invention. Il est à noter que seul le dernier niveau de métallisation du premier empilement est représenté par souci de simplification. Le matériau diélectrique dans lequel sont noyés les empilements de niveaux de métallisation n'est pas représenté par souci de lisibilité.

Par ailleurs, il est à noter que les dessins décrits ci-avant sont schématiques, et ne sont pas à l'échelle par souci de lisibilité et pour en simplifier leur compréhension. Les coupes sont effectuées suivant la normale aux surfaces des substrats.

### Exposé détaillé des modes de réalisation

Les éléments identiques ou assurant la même fonction porteront les mêmes références pour les différents modes de réalisation, par souci de simplification.

Un objet de l'invention est un procédé de protection d'un étage supérieur TT de composants électroniques C d'un circuit intégré contre l'effet d'antenne, comportant les étapes :
a) prévoir une première structure comportant successivement :
   - un premier substrat 1, semi-conducteur, présentant des première et seconde surfaces 10, 11 opposées, la première surface 10 du premier substrat 1 étant destinée à être électriquement connectée à une électrode de polarisation E₁,
   - un premier étage BT de composants électroniques C, formé à la seconde surface 11 du premier substrat 1,
   - un premier empilement de niveaux de métallisation, agencé pour connecter électriquement les composants électroniques C du premier étage BT, et présentant un dernier niveau de métallisation M_{N} électriquement connecté à la seconde surface 11 du premier substrat 1 ;
b) prévoir une deuxième structure comportant :
   - un deuxième substrat 2, semi-conducteur, présentant des première et seconde surfaces 20, 21 opposées, le deuxième substrat 2 comprenant un trou d'interconnexion traversant 22,
   - un deuxième étage TT de composants électroniques C, formé à la première surface 20 du deuxième substrat 2, et comprenant des composants de protection 200 ;3 agencés pour évacuer des charges électriques dans le deuxième substrat 2 ;
c) assembler les première et deuxième structures de sorte que la seconde surface 21 du deuxième substrat 2 est orientée vers le premier empilement de niveaux de métallisation, et de sorte que le trou d'interconnexion traversant 22 est électriquement connecté au dernier niveau de métallisation M_{N} du premier empilement ;
d) former un deuxième empilement de niveaux de métallisation, agencé pour connecter électriquement les composants électroniques C du deuxième étage TT ; l'étape d) étant exécutée de sorte que le deuxième empilement présente un premier niveau de métallisation M₁ électriquement connecté au trou d'interconnexion traversant 22 et à la première surface 20 du deuxième substrat 2.

Autrement dit, l'étape a) est exécutée de sorte que le premier empilement de niveaux de métallisation présente un dernier niveau de métallisation M_{N} comprenant un motif électriquement connecté à la seconde surface 11 du premier substrat 1.

Autrement dit, l'étape b) est exécutée de sorte que le deuxième étage TT comporte :
- des composants électroniques C, à protéger contre l'effet d'antenne ;
- des composants de protection 200 ; 3, distincts des composants électroniques C à protéger contre l'effet d'antenne, agencés pour évacuer des charges électriques dans le deuxième substrat 2.

En d'autres termes, les composants électroniques C du deuxième étage TT et les composants de protection 200 ; 3 du deuxième étage TT sont des entités distinctes, ne pouvant être confondues. Chaque composant de protection 200 ; 3 ne fait pas partie intégrante d'un composant électronique C à protéger contre l'effet d'antenne.

Autrement dit, l'étape c) est exécutée de sorte que le trou d'interconnexion traversant 22 est électriquement connecté au motif du dernier niveau de métallisation M_{N} du premier empilement.

Autrement dit, l'étape d) est exécutée de sorte que le deuxième empilement de niveaux de métallisation présente un premier niveau de métallisation M₁ comprenant un motif électriquement connecté au trou d'interconnexion traversant 22 et à la première surface 20 du deuxième substrat 2.

L'étape d) utilise une gravure par un plasma. L'étape d) est exécutée après l'étape c).

L'assemblage des première et deuxième structures avec le premier niveau de métallisation M₁ du deuxième empilement formé est illustré aux figures 2 et 3.

### Etape a)

Le premier substrat 1 de la première structure prévue lors de l'étape a) est avantageusement dopé d'un premier type de conductivité, de préférence dopé de type p. Le premier substrat 1 peut présenter une épaisseur comprise entre 10 µm et plusieurs centaines de µm (par exemple 500 µm).

Le premier empilement de niveaux de métallisation peut présenter une épaisseur comprise entre 100 nm et 200 nm. Pour une technologie 28 nm (c'est-à-dire lorsque les composants électroniques C sont des transistors avec une longueur de grille de 28 nm) avec 11 niveaux de métallisation, le premier empilement de niveaux de métallisation peut présenter une épaisseur de l'ordre de 4,5 µm.

L'étape a) est avantageusement exécutée de sorte que :
- le premier substrat 1 est dopé d'un premier type de conductivité,
- une zone fortement dopée 110, du premier type de conductivité ou d'un second type de conductivité, est formée à la seconde surface 11 du premier substrat 1,
- le dernier niveau de métallisation M_{N} du premier empilement est électriquement connecté à la zone fortement dopée 110, par exemple à l'aide d'un trou d'interconnexion 111.

Autrement dit, l'étape a) est exécutée de sorte que le motif du dernier niveau de métallisation M_{N} du premier empilement est électriquement connecté à la zone fortement dopée 110.

L'étape a) est avantageusement exécutée de sorte que les composants électroniques C du premier étage BT, hormis les composants de protection 200 ; 3, sont choisis parmi :
- des transistors à effet de champ de type MOS formés sur un substrat 1, 2 massif,
- des transistors à effet de champ de type MOS formés sur un substrat 1, 2 de type SOI,
- des transistors à effet de champ de type MOS à ailettes formés sur un substrat 1, 2 massif,
- des transistors à effet de champ de type MOS à ailettes formés sur un substrat 1, 2 de type SOI, et
- des mémoires résistives à base d'oxyde.

Un seul composant électronique C est illustré aux figures 2 et 3, par souci de lisibilité ; il s'agit un transistor à effet de champ de type MOS, comportant une source S, une grille G, un drain D et une couche d'oxyde Ox, et formé sur le premier substrat 1 massif.

L'étape a) est avantageusement exécutée de sorte que le premier substrat 1 est une plaquette réalisée en silicium. Le premier substrat 1 peut être un substrat de type SOI.

L'étape a) comporte avantageusement les étapes :
a₁) prévoir le premier substrat 1, semi-conducteur, présentant des première et seconde surfaces 10, 11 opposées, la première surface 10 du premier substrat 1 étant destinée à être électriquement connectée à une électrode de polarisation E₁ ;
a₂) former le premier étage BT de composants électroniques C à la seconde surface 11 du premier substrat 1 ; l'étape a₂) étant exécutée par une unité de fabrication initiale ;
a₃) former le premier empilement de niveaux de métallisation, agencé pour connecter électriquement les composants électroniques C du premier étage BT, et présentant un dernier niveau de métallisation M_{N} électriquement connecté à la seconde surface 11 du premier substrat 1 ; l'étape a₃) étant exécutée par une unité de fabrication finale.

Autrement dit, l'étape a₃) est exécutée de sorte que le premier empilement de niveaux de métallisation présente un dernier niveau de métallisation M_{N} comprenant un motif électriquement connecté à la seconde surface 11 du premier substrat 1.

### Etape b)

Le deuxième substrat 2 de la deuxième structure prévue lors de l'étape b) est avantageusement dopé d'un premier type de conductivité, de préférence dopé de type p. Le deuxième substrat 2 présente une épaisseur strictement inférieure à l'épaisseur du premier substrat 1. Le deuxième substrat 2 présente avantageusement une épaisseur inférieure à 1 µm.

L'étape b) est avantageusement exécutée de sorte que les composants électroniques C du deuxième étage TT, hormis les composants de protection 200 ; 3, sont choisis parmi :
- des transistors à effet de champ de type MOS formés sur un substrat 1, 2 massif,
- des transistors à effet de champ de type MOS formés sur un substrat 1, 2 de type SOI,
- des transistors à effet de champ de type MOS à ailettes formés sur un substrat 1, 2 massif,
- des transistors à effet de champ de type MOS à ailettes formés sur un substrat 1, 2 de type SOI, et
- des mémoires résistives à base d'oxyde.

Un seul composant électronique C est illustré aux figures 2 et 3, par souci de lisibilité ; il s'agit un transistor à effet de champ de type MOS, comportant une source S, une grille G, un drain D et une couche d'oxyde Ox, et formé sur le deuxième substrat 2 massif.

L'étape b) est avantageusement exécutée de sorte que le deuxième substrat 2 est une plaquette réalisée en silicium. Le deuxième substrat 2 peut être un substrat de type SOI.

L'étape b) est exécutée de sorte que le trou d'interconnexion traversant 22 s'étend en regard d'une zone libre de la seconde surface 21 du deuxième substrat 2, c'est-à-dire une zone de la seconde surface 21 du deuxième substrat non recouverte de composants électroniques C.

L'étape b) comporte avantageusement les étapes :
b₁) prévoir le deuxième substrat 2, semi-conducteur, présentant des première et seconde surfaces 20, 21 opposées, le deuxième substrat 2 comprenant un trou d'interconnexion traversant 22 ;
b₂) former le deuxième étage TT de composants électroniques C à la première surface 20 du deuxième substrat 2 ; l'étape b₂) étant exécutée par une unité de fabrication initiale.

Selon un mode de mise en œuvre, illustré à la figure 2, lorsque l'étape b) est exécutée de sorte que le deuxième substrat 2 est dopé d'un premier type conductivité, l'étape b) comporte avantageusement une étape b₃) consistant à former une première zone dopée 200, d'un second type de conductivité, à la première surface 20 du deuxième substrat 2 de manière à former une jonction p-n. La jonction p-n est destinée à être polarisée en inverse de manière à obtenir un composant de protection 200.

Selon un mode de mise en œuvre alternatif, illustré à la figure 3, l'étape b) comporte une étape b'₃) consistant à former une capacité 3 de type MOS à la première surface 20 du deuxième substrat 2 de manière à obtenir un composant de protection 3. Une capacité 3 de type MOS comporte une structure de transistor où la source S, le drain D et le deuxième substrat 2 sont connectés ensemble.

Lorsque l'étape b) est exécutée de sorte que le deuxième substrat 2 est dopé du premier type conductivité, l'étape b) comporte avantageusement une étape b₄) consistant à former une deuxième zone dopée 200', fortement dopée du premier type de conductivité, à la première surface 20 du deuxième substrat 2.

### Etape c)

L'étape c) est avantageusement exécutée par un collage par adhésion moléculaire entre les première et deuxième structures par l'intermédiaire d'au moins une couche d'oxyde (non illustrée). La ou les couches d'oxyde peuvent être réalisées en SiO₂.

### Etape d)

L'étape d) est exécutée de sorte que le premier niveau de métallisation M₁ du deuxième empilement comporte un premier ensemble de lignes d'interconnexions (lignes de routage) agencé pour connecter électriquement les composants électroniques C du deuxième étage TT. L'étape d) est exécutée de sorte que le premier niveau de métallisation M₁ du deuxième empilement comporte un deuxième ensemble de lignes d'interconnexions (lignes de routage) agencé pour connecter électriquement le trou d'interconnexion traversant 22 et la première surface 20 du deuxième substrat 2. Les premier et deuxième ensembles de lignes d'interconnexions sont électriquement isolés entre eux. Les lignes d'interconnexions du premier ensemble sont électriquement isolées entre elles de manière à ne pas mettre en court-circuit les composants électroniques C.

Comme illustré à la figure 2, lorsque l'étape b) comporte l'étape b₃) consistant à former la première zone dopée 200, d'un second type de conductivité, à la première surface 20 du deuxième substrat 2 de manière à former la jonction p-n, alors l'étape d) est exécutée de sorte que le premier niveau de métallisation M₁ du deuxième empilement est électriquement connecté à la première zone dopée 200 formée lors de l'étape b₃), par exemple à l'aide d'un trou d'interconnexion 201. Autrement dit, l'étape d) est exécutée de sorte que le motif du premier niveau de métallisation M₁ du deuxième empilement est électriquement connecté à la première zone dopée 200 formée lors de l'étape b₃).

Comme illustré à la figure 3, lorsque l'étape b) comporte l'étape b'₃) consistant à former la capacité 3 de type MOS à la première surface 20 du deuxième substrat 2, alors l'étape d) est exécutée de sorte que le premier niveau de métallisation M₁ du deuxième empilement est électriquement connecté à la capacité 3 de type MOS formée lors de l'étape b'₃), par exemple à l'aide d'un trou d'interconnexion 30. Autrement dit, l'étape d) est exécutée de sorte que le motif du premier niveau de métallisation M₁ du deuxième empilement est électriquement connecté à la capacité 3 de type MOS formée lors de l'étape b'₃).

Lorsque l'étape b) comporte l'étape b₄) consistant à former la deuxième zone dopée 200', fortement dopée du premier type de conductivité, à la première surface 20 du deuxième substrat 2, alors l'étape d) est exécutée de sorte que le premier niveau de métallisation M₁ du deuxième empilement est électriquement connecté à la deuxième zone dopée 200' formée lors de l'étape b₄), par exemple à l'aide d'un trou d'interconnexion 201'. Autrement dit, l'étape d) est exécutée de sorte que le motif du premier niveau de métallisation M₁ du deuxième empilement est électriquement connecté à la deuxième zone dopée 200' formée lors de l'étape b₄).

L'étape d) est avantageusement exécutée par une unité de fabrication finale. Le deuxième empilement de niveaux de métallisation peut présenter une épaisseur comprise entre 100 nm et 200 nm. Pour une technologie 28 nm (c'est-à-dire lorsque les composants électroniques C sont des transistors avec une longueur de grille de 28 nm) avec 11 niveaux de métallisation, le deuxième empilement de niveaux de métallisation peut présenter une épaisseur de l'ordre de 4,5 µm.

L'invention ne se limite pas aux modes de réalisation exposés. L'homme du métier est mis à même de considérer leurs combinaisons techniquement opérantes, et de leur substituer des équivalents.

## Revendications

1. Procédé de protection d'un étage supérieur (TT) de composants électroniques (C) d'un circuit intégré contre l'effet d'antenne, comportant les étapes :
a) prévoir une première structure comportant successivement :
- un premier substrat (1), semi-conducteur, présentant des première et seconde surfaces (10, 11) opposées, la première surface (10) du premier substrat (1) étant destinée à être électriquement connectée à une électrode de polarisation (E₁),
- un premier étage (BT) de composants électroniques (C), formé à la seconde surface (11) du premier substrat (1),
- un premier empilement de niveaux de métallisation, agencé pour connecter électriquement les composants électroniques (C) du premier étage (BT), et présentant un dernier niveau de métallisation (M_{N}) comprenant un motif électriquement connecté à la seconde surface (11) du premier substrat (1) ;
b) prévoir une deuxième structure comportant :
- un deuxième substrat (2), semi-conducteur, présentant des première et seconde surfaces (20, 21) opposées, le deuxième substrat (2) comprenant un trou d'interconnexion traversant (22),
- un deuxième étage (TT) de composants électroniques (C), formé à la première surface (20) du deuxième substrat (2), et comprenant des composants de protection (200 ; 3), distincts des composants électroniques (C), agencés pour évacuer des charges électriques dans le deuxième substrat (2) ;
c) assembler les première et deuxième structures de sorte que la seconde surface (21) du deuxième substrat (2) est orientée vers le premier empilement de niveaux de métallisation, et de sorte que le trou d'interconnexion traversant (22) est électriquement connecté au motif du dernier niveau de métallisation (M_{N}) du premier empilement ;
d) former un deuxième empilement de niveaux de métallisation, agencé pour connecter électriquement les composants électroniques (C) du deuxième étage (TT) ; l'étape d) étant exécutée de sorte que le deuxième empilement présente un premier niveau de métallisation (M₁) comprenant un motif électriquement connecté au trou d'interconnexion traversant (22) et à la première surface (20) du deuxième substrat (2) ; l'étape d) utilisant une gravure par un plasma, l'étape d) étant exécutée après l'étape c).

2. Procédé selon la revendication 1, dans lequel l'étape b) est exécutée de sorte que le deuxième substrat (2) est dopé d'un premier type conductivité ; l'étape b) comporte une étape b₃) consistant à former une première zone dopée (200), d'un second type de conductivité, à la première surface (20) du deuxième substrat (2) de manière à former une jonction p-n ; la jonction p-n étant destinée à être polarisée en inverse de manière à obtenir un composant de protection (200) ; et l'étape d) est exécutée de sorte que le motif du premier niveau de métallisation (M₁) du deuxième empilement est électriquement connecté à la première zone dopée (200) formée lors de l'étape b₃).

3. Procédé selon la revendication 1, dans lequel l'étape b) comporte une étape b'₃) consistant à former une capacité (3) de type MOS à la première surface (20) du deuxième substrat (2) de manière à obtenir un composant de protection (3) ; et l'étape d) est exécutée de sorte que le motif du premier niveau de métallisation (M₁) du deuxième empilement est électriquement connecté à la capacité (3) de type MOS formée lors de l'étape b'₃).

4. Procédé selon l'une des revendications 1 à 3, dans lequel l'étape a) est exécutée de sorte que :
- le premier substrat (1) est dopé d'un premier type de conductivité,
- une zone fortement dopée (110), du premier type de conductivité ou d'un second type de conductivité, est formée à la seconde surface (11) du premier substrat (1),
- le motif du dernier niveau de métallisation (M_{N}) du premier empilement est électriquement connecté à la zone fortement dopée (110).

5. Procédé selon l'une des revendications 1 à 4, dans lequel les étapes a) et b) sont exécutées de sorte que les composants électroniques (C) des premier et deuxième étages (BT, TT), hormis les composants de protection (200 ; 3), sont choisis parmi :
- des transistors à effet de champ de type MOS formés sur un substrat (1, 2) massif,
- des transistors à effet de champ de type MOS formés sur un substrat (1, 2) de type SOI,
- des transistors à effet de champ de type MOS à ailettes formés sur un substrat (1, 2) massif,
- des transistors à effet de champ de type MOS à ailettes formés sur un substrat (1, 2) de type SOI, et
- des mémoires résistives à base d'oxyde.

6. Procédé selon l'une des revendications 1 à 5, dans lequel les étapes a) et b) sont exécutées de sorte que les premier et deuxième substrats (1, 2) sont des plaquettes réalisées en silicium.

7. Procédé selon l'une des revendications 1 à 6, dans lequel l'étape a) comporte les étapes :
a₁) prévoir le premier substrat (1), semi-conducteur, présentant des première et seconde surfaces (10, 11) opposées, la première surface (10) du premier substrat (1) étant destinée à être électriquement connectée à une électrode de polarisation (E₁) ;
a₂) former le premier étage (BT) de composants électroniques (C) à la seconde surface (11) du premier substrat (1) ; l'étape a₂) étant exécutée par une unité de fabrication initiale ;
a₃) former le premier empilement de niveaux de métallisation, agencé pour connecter électriquement les composants électroniques (C) du premier étage (BT), et présentant un dernier niveau de métallisation (M_{N}) comprenant un motif électriquement connecté à la seconde surface (11) du premier substrat (1) ; l'étape a₃) étant exécutée par une unité de fabrication finale.

8. Procédé selon l'une des revendications 1 à 7, dans lequel l'étape b) comporte les étapes :
b₁) prévoir le deuxième substrat (2), semi-conducteur, présentant des première et seconde surfaces (20, 21) opposées, le deuxième substrat (2) comprenant un trou d'interconnexion traversant (22) ;
b₂) former le deuxième étage (TT) de composants électroniques (C) à la première surface (20) du deuxième substrat (2) ; l'étape b₂) étant exécutée par une unité de fabrication initiale.

9. Procédé selon l'une des revendications 1 à 8, dans lequel l'étape d) est exécutée par une unité de fabrication finale.

10. Procédé selon l'une des revendications 1 à 9, dans lequel l'étape c) est exécutée par un collage par adhésion moléculaire entre les première et deuxième structures par l'intermédiaire d'au moins une couche d'oxyde.

11. Procédé selon l'une des revendications 1 à 10, dans lequel l'étape b) est exécutée de sorte que le deuxième substrat (2) est dopé d'un premier type conductivité ; l'étape b) comporte une étape b₄) consistant à former une deuxième zone dopée (200'), fortement dopée du premier type de conductivité, à la première surface (20) du deuxième substrat (2) ;
et l'étape d) est exécutée de sorte que le motif du premier niveau de métallisation (M₁) du deuxième empilement est électriquement connecté à la deuxième zone dopée (200') formée lors de l'étape b₄).
